(19) **Europäisches Patentamt / European Patent Office / Office européen des brevets**

(11) **EP 2 933 649 B1**

(12) **EUROPEAN PATENT SPECIFICATION**

(45) Date of publication and mention
of the grant of the patent:
**10.05.2017  Bulletin 2017/19**

(51) Int Cl.:
***G01R 31/36*** *(2006.01)*     ***H02J 7/00*** *(2006.01)*

(21) Application number: **15152222.4**

(22) Date of filing: **22.01.2015**

(54) **Model-independent battery life and performance forecaster**

Modellunabhängiger Batterielebensdauer- und Leistungsvorhersager

Dispositif de prédiction de la durée de vie et des performances d'une batterie indépendamment du modèle

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.03.2014  US 201414224902**

(43) Date of publication of application:
**21.10.2015  Bulletin 2015/43**

(73) Proprietor: **The Boeing Company
Chicago, IL 60606-1596 (US)**

(72) Inventor: **Liu, Shengyi
Chicago, IL 60606-2016 (US)**

(74) Representative: **Cabinet Plasseraud
66 rue de la Chaussée d'Antin
75440 Paris Cedex 09 (FR)**

(56) References cited:
**EP-A1- 1 460 709     US-A- 5 404 106**

EP 2 933 649 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**FIELD OF THE DISCLOSURE**

The present disclosure relates to estimating parameters indicating battery life and performance of a rechargeable battery.

**BACKGROUND**

Rechargeable batteries are used to supply power to a wide variety of devices. During a lifetime of a rechargeable battery, performance of the rechargeable battery may degrade as materials capable of holding an electric charge are lost. This is known as an "aging effect." Performance of the rechargeable battery may be monitored by monitoring parameters of the rechargeable battery, such as capacity and internal resistance. Capacity refers to an amount of electric charge stored in the rechargeable battery when the rechargeable battery is fully charged. Internal resistance refers to an equivalent series resistance of the rechargeable battery. The capacity and internal resistance may be measured, but such measurements are time-consuming and cannot be performed during use of the rechargeable battery.

One way to avoid performing the time-consuming measurements is to estimate the capacity and the internal resistance based on measurements performed during use of the rechargeable battery. The capacity and the internal resistance are estimated by comparing real-time measurements of battery parameters to a statistical model (e.g., a data model) associated with a specific type of the rechargeable battery being used. However, generating the statistical model incurs significant time and resource costs. For example, to generate the statistical model, testing is performed on a large number of rechargeable batteries. The batteries are monitored during repeated charging and discharging cycles and measurements are recorded. The measurements from the rechargeable batteries are correlated to create a statistical model representing an average rechargeable battery of the specific type. The testing process uses up the batteries involved. Thus, generating the statistical model requires significant resources to perform the testing as well as using up a large number of rechargeable batteries. If more than one type of rechargeable battery is used, additional statistical models are generated based test data of additional rechargeable batteries.

As well as requiring significant resources to generate statistical models, estimation based on statistical models results in estimated values that are based on performance of an average rechargeable battery. Performance of a particular rechargeable battery being used may vary from the performance of the average rechargeable battery, thus adding inaccuracies to the estimated values. Additionally, most statistical models are based on a full charge operation followed by a full discharge operation. The full charge operation and the full discharge operation may not accurately reflect use of a rechargeable battery in the field, thus adding additional inaccuracies to the estimated values. Document EP1460709 discloses a method for estimating remaining capacity of batteries based on a calculation of electromotive force. That is to say in the wording of claim 1, document EP1460709 discloses a method comprising: repeatedly measuring parameters of a rechargeable battery during an effective power cycle of the rechargeable battery, the parameters including a current provided by the rechargeable battery, a voltage across the rechargeable battery, and a temperature of the rechargeable battery, wherein the effective power cycle includes multiple charge operations and multiple discharge operations; estimating a remaining capacity of the rechargeable battery based on the current, the voltage, and the temperature; and generating an output indicating the remaining capacity.

**SUMMARY**

Particular embodiments disclosed herein describe a model-independent battery forecaster configured to estimate battery parameters indicating battery life and performance. For example, the battery parameters may be estimated independently of a statistical model (e.g., a data model) associated with a rechargeable battery. The battery parameters may also be estimated independently of a type of the rechargeable battery being used. Thus, the battery forecaster eliminates time and resource intensive generation of type-specific statistical models.

The invention is defined by the features of the independent claims 1 and 6. Preferred embodiments are defined in the dependent claims.

To estimate the battery parameters indicating battery life and battery performance, other battery parameters of the rechargeable battery, such as current, voltage, and temperature, may be determined (e.g., measured) during an effective power cycle of the rechargeable battery. The effective power cycle may include multiple charge operations and multiple discharge operations. The charge operations and the discharge operations may occur in any order, and each charge operation or discharge operation may transfer less than a full capacity of the rechargeable battery. Thus, the effective power cycle is not limited to consecutive full charge operations and full discharge operations.

Upon completion of the effective power cycle, a remaining capacity, an internal resistance, and a reversible potential of the rechargeable battery may be estimated based on the current, the voltage, and the temperature. The remaining capacity may be associated with a remaining life of the rechargeable battery. Thus, knowledge of the remaining capacity and use conditions of the rechargeable battery enables estimation of the remaining life of the rechargeable battery. The internal resistance and the reversible

potential may indicate power performance of the rechargeable battery, such as a maximum achievable power output of a next discharge operation. The remaining capacity, the internal resistance, and the reversible potential may be estimated based on the current, the voltage, and the temperature without a comparison to any statistical models. Additional data, such as changes in the remaining capacity, the internal resistance, and the reversible potential during the effective power cycle may be generated based on the estimated values. The additional data may indicate performance trends of the rechargeable battery.

In an aspect of a particular embodiment, a method includes determining parameters of a rechargeable battery during an effective power cycle of the rechargeable battery. The parameters include a current provided by the rechargeable battery, a voltage across the rechargeable battery, and a temperature of the rechargeable battery. The effective power cycle includes multiple charge operations and multiple discharge operations. The method includes estimating a remaining capacity of the rechargeable battery based on the current, the voltage, and the temperature. The method also includes generating an output indicating the remaining capacity.

In an aspect of another particular embodiment, a system includes a battery monitor configured to determine parameters of a rechargeable battery during an effective power cycle of the rechargeable battery. The parameters include a current provided by the rechargeable battery, a voltage across the rechargeable battery, and a temperature of the rechargeable battery. The effective power cycle includes multiple charge operations and multiple discharge operations. The system includes a battery forecaster configured to estimate a remaining capacity of the rechargeable battery based on the current, the voltage, and the temperature. The system also includes a memory coupled to the battery forecaster, the memory configured to store a data log including data indicating the remaining capacity.

Further, a computer-readable storage device stores instructions that, when executed by a processor, cause the processor to perform operations. The operations include determining parameters of a rechargeable battery during an effective power cycle of the rechargeable battery. The parameters include a current provided by the rechargeable battery, a voltage across the rechargeable battery, and a temperature of the rechargeable battery. The effective power cycle includes multiple charge operations and multiple discharge operations. The operations include estimating a remaining capacity of the rechargeable battery based on the current, the voltage, and the temperature. The operations also include generating an output indicating the remaining capacity.

The features, functions, and advantages that have been described can be achieved independently in various embodiments or may be combined in yet other embodiments, further details of which are disclosed with reference to the following description and drawings.

## BRIEF DESCRIPTION OF THE DRAWINGS

FIG. 1 is a block diagram that illustrates a particular embodiment of a system to estimate parameters indicating battery life and battery performance of a rechargeable battery;

FIGS. 2A-B are a flow chart of a particular embodiment of a method of estimating parameters indicating battery life and battery performance of a rechargeable battery during a lifetime of the rechargeable battery;

FIG. 3 is a flow chart of a particular embodiment of a method of estimating a remaining capacity of a rechargeable battery; and

FIG. 4 is a block diagram that illustrates a particular embodiment of a computing system to estimate parameters indicating battery life and battery performance of a rechargeable battery.

## DETAILED DESCRIPTION

Particular embodiments of the present disclosure are described below with reference to the drawings. In the description, common features are designated by common reference numbers throughout the drawings.

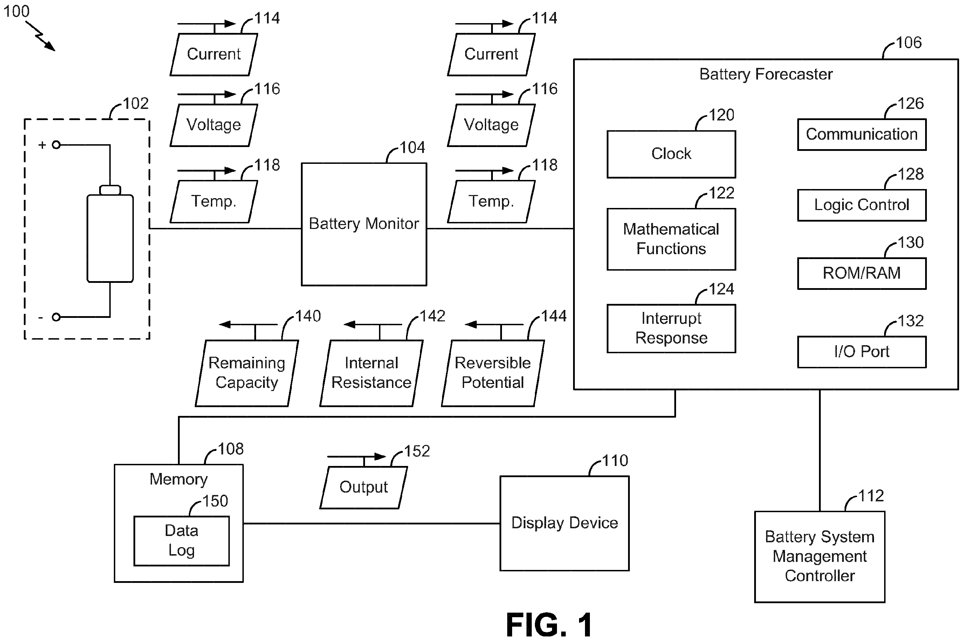

Referring to FIG. 1, a particular embodiment of a system to estimate parameters indicating battery life and battery performance of a rechargeable battery is depicted and generally designated 100. The system 100 includes a rechargeable battery 102, a battery monitor 104, a battery forecaster 106, a memory 108, a display device 110, and a battery system management controller 112. The system 100 enables estimation of one or more parameters that indicate remaining life and/or battery performance of the rechargeable battery 102. Although illustrated as individual components, in a particular embodiment, the system 100 may be included in a device that is powered by or coupled to the rechargeable battery 102.

The rechargeable battery 102 may be any type of rechargeable battery. For example, the rechargeable battery 102 may be a lithium battery or a lead-acid battery. The rechargeable battery 102 may be configured to power an aircraft, a spacecraft, a land craft, a computing device, a wireless device, or any other type of device. During use of the rechargeable battery 102 (e.g., while the rechargeable battery 102 powers a particular device), the rechargeable battery 102 may be monitored, as further described herein, so that the battery forecaster 106 may estimate one or more parameters of the rechargeable battery 102.

The battery monitor 104 may be configured to monitor the rechargeable battery 102 during use and to determine (e.g., measure values corresponding to) one or more parameters of the rechargeable battery 102. The battery monitor 104 may be coupled to the battery forecaster 106 and may be configured to provide the parameters to the battery forecaster 106. For example, the battery monitor 104 may include one or more sensors configured to measure the parameter values, such as a current 114 provided by the rechargeable battery 102, a voltage 116 across the rechargeable battery 102, and a temperature 118 of the rechargeable battery 102. The values of the parameters may be measured in real-time during use of the rechargeable battery 102. Although described as internal to the battery monitor 104, in an alternate embodiment, the sensors may be external to the battery monitor 104 and may provide measurements corresponding to the parameters to the battery monitor 104. The battery monitor 104 may be further configured to perform signal processing on the current 114, the voltage 116, and the temperature 118. For example, the current 114, the voltage 116, and the temperature 118 may be measured as analog signals, and the battery monitor 104 may be configured to perform analog-to-digital (A/D) conversion to convert the analog signals to digital signals. The battery monitor 104 may also perform anti-alias filtering on the signals.

The battery forecaster 106 may be configured to estimate one or more parameters indicating battery life or battery performance based on the current 114, the voltage 116, and the temperature 118, as further described herein. The battery forecaster 106 may include one or more processing modules, such as a clock module 120, a mathematical function module 122, an interrupt response module 124, a communication module 126, a logic control module 128, a ROM/RAM 130, and an input/output (I/O) port 132. The processing modules 120-132 may be configured to perform one or more operations or to store one or more values to enable the battery forecaster 106 to estimate the parameters based on the current 114, the voltage 116, and the temperature 118. The example illustrated in FIG. 1 is not limiting. For example, in other embodiments, the battery forecaster 106 may include only a subset (e.g., not all) of the processing modules 120-132.

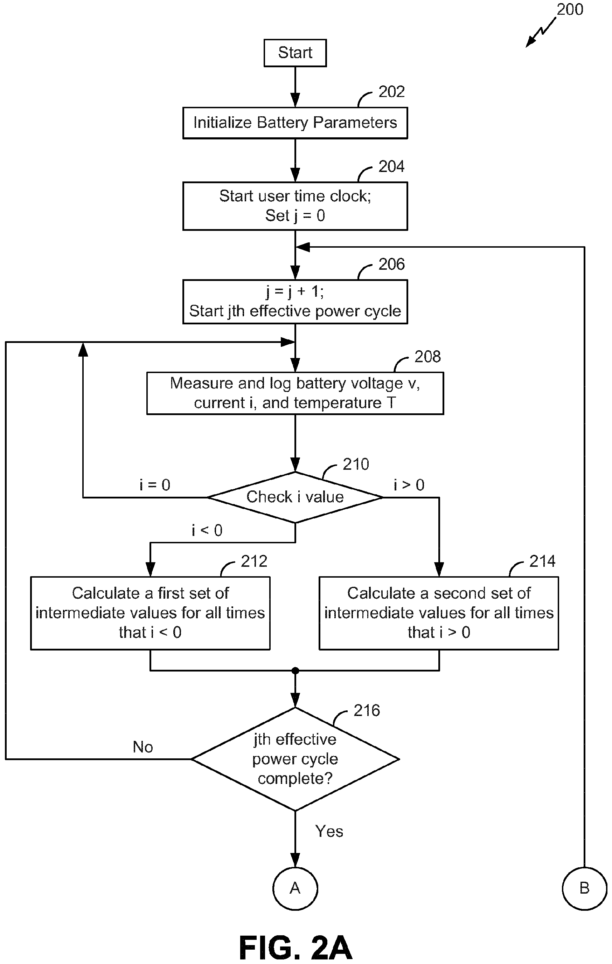

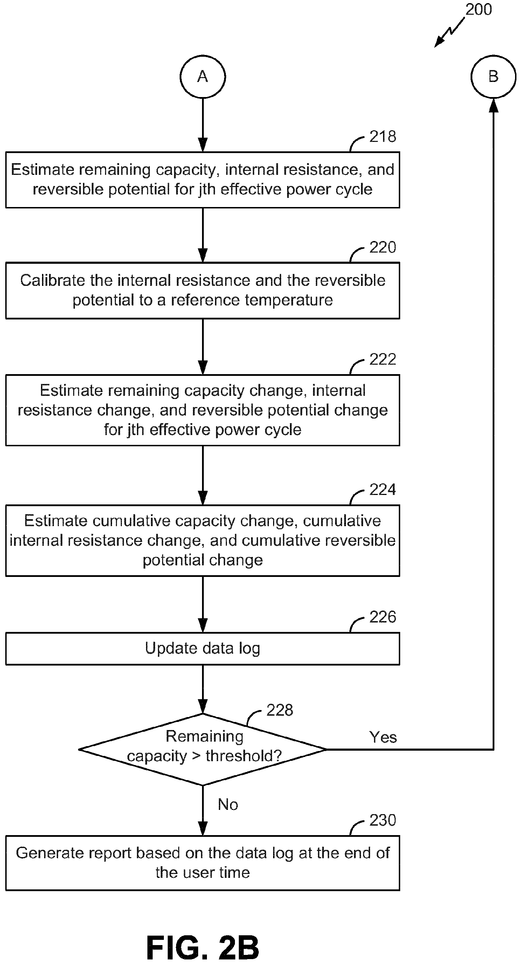

The parameters estimated by the battery forecaster 106 may include a remaining capacity 140, an internal resistance 142, and a reversible potential 144. The battery forecaster 106 may also be configured to estimate changes in the remaining capacity 140, the internal resistance 142, and the reversible potential 144 as compared to a previous effective power cycle or as compared to initial values, as further described with reference to FIGS. 2A-B. The battery forecaster 106 may be configured to provide data indicating the estimated parameters to the memory 108 upon completion of each effective power cycle. Operation of the battery forecaster 106 may be controlled by the battery system management controller 112.

The memory 108 may include a data log 150. The data log 150 may be configured to store data indicating estimated parameters for each of one or more effective power cycles. For example, the data log 150 may store data indicating the remaining capacity 140, the internal resistance 142, and the reversible potential 144 for each of multiple effective power cycles. The memory 108 may also be configured to generate an output 152 based on the data log 150 and to provide the output 152 to the display device 110. The display device 110 may be configured to display the output 152. For example, the display device 110 may be configured to display battery life and battery performance information of the rechargeable battery 102. The battery life and battery performance information may be a report based on the data log 150.

During operation, the battery monitor 104 may monitor the rechargeable battery 102 and may measure parameters of the rechargeable battery 102, including the current 114, the voltage 116, and the temperature 118, during an effective power cycle of the rechargeable battery. The battery forecaster 106 may receive values of the current 114, the voltage 116, and the temperature 118 from the battery monitor 104. The battery forecaster 106 may determine an end of the effective power cycle and, in response to the determination, may estimate the remaining capacity 140, the internal resistance 142, and the reversible potential 144 based on the current 114, the voltage 116, and the temperature 118. The effective power cycle may include multiple charge operations and multiple discharge operations of the rechargeable battery 102. Determination of the end of the effective power cycle and estimation of the remaining capacity 140, the internal resistance 142, and the reversible potential 144 are described in further detail with reference to FIGS. 2A-B. Data indicating the estimated parameters 140-144 as well as any additional estimated parameters may be provided to the memory 108 and may be stored in the data log 150. The output 152 based on the data log 150 may be generated and provided to the display device 110 for display to a user. Additionally or alternatively, the output 152 may be based on the data indicating the estimated parameters 140-144 (e.g., without storage in the memory 108).

The battery forecaster 106 enables estimation of parameters indicating battery life and battery performance of the rechargeable battery 102 without using a lookup table to compare measured values to a statistical model. Thus, the battery forecaster 106 enables estimation of the parameters independently of a statistical model (e.g., a data model). The battery forecaster 106 uses less memory than a forecaster that stores data from a statistical model in a lookup table. The battery forecaster 106 also reduces costs by eliminating the testing and generation of the statistical model. Additionally, the battery forecaster 106 may estimate parameters of any type of rechargeable battery. Additionally, because the battery forecaster 106 uses real-time measurements of the rechargeable battery 102, inaccuracies based on performance-variance are reduced.

Referring to FIGS. 2A-B, a flow chart of a particular embodiment of a method 200 of estimating parameters indicating battery life and battery performance of a rechargeable battery during a lifetime of the rechargeable battery is depicted. The method 200 may be performed by a battery forecaster, such as the battery forecaster 106 of FIG. 1, for a rechargeable battery, such as the rechargeable battery 102 of FIG. 1.

The method 200 begins and battery parameters are initialized, at 202. The battery parameters may be initialized based on a user input. For example, a user input indicating initial values may be received at the battery forecaster. The initial values may be determined based on simple offline tests and measurements of the rechargeable battery 102. The initial values may include an initial reversible potential $E_{0,ref}$, an initial internal resistance $R_{0,ref}$, an initial capacity $C_0$, an initial state of charge $soc_0$, a reference temperature $T_{ref}$, a battery temperature coefficient $\alpha$, a battery data sampling time step $\Delta t$, an input error parameter $\varepsilon$, or a combination thereof. In a particular embodiment, the reference temperature $T_{ref}$ may be pre-set to a value associated with room temperature (298 K). The battery parameters may be initialized based on the initial values. After initialization, the battery parameters (e.g., the initial values) may be used in estimating other battery parameters, as further described herein.

A user time clock may be started, at 204. For example, the battery forecaster may start a clock corresponding to user time. The clock may track a duration of use of the battery by a particular user (e.g., user time). Additionally, a variable j configured to track a current effective power cycle may be initialized to zero.

A value of j may be incremented by one, at 206. The battery forecaster may increment the value of j to indicate a beginning of a current effective power cycle (e.g., a jth effective power cycle). An effective power cycle may include multiple charge operations and multiple discharge operations of the rechargeable battery (e.g., the effective power cycle is not limited to a full charge operation followed consecutively by a full discharge operation). The multiple charge operations and the multiple discharge operations may occur in any order and each may transfer less than or equal to the capacity of the battery. The current (e.g., jth) effective power cycle may continue until a first amount of electric charge associated with the multiple charge operations and a second amount of electric charge associated with the multiple discharge operations each approximate a remaining capacity associated with a previous effective power cycle, as further described herein. The first amount of electric charge applied to the rechargeable battery during the multiple charge operations and the second amount of electric charge discharged from the rechargeable battery during the multiple discharge operations each may approximate a previous remaining capacity $C_{j-1}$ of a previous effective power cycle. A degree of approximation between the first amount of electric charge (or the second amount of electric charge) and the previous remaining capacity $C_{j-1}$ may be based on the input error parameter $\varepsilon$. A time period (e.g., a duration) $\Delta t_j$ of the jth effective power cycle may satisfy Equation 1, where E is a reversible potential of the rechargeable battery, i is a current provided by the rechargeable battery, and $\overline{E}_j$ is a reversible potential of the rechargeable battery associated with the jth effective power cycle:

$$\int_{\Delta t_j} E \cdot |i| \cdot dt = 2 \cdot C_{j-1} \cdot \overline{E}_j \qquad\qquad \text{Equation (1)}$$

Parameters of the rechargeable battery may be measured during the jth effective power cycle, at 208. For example, the battery forecaster may measure values of the parameters directly from the rechargeable battery or may receive measurements from another system component, such as the battery monitor 104 of FIG. 1. The parameters may include a current i provided by the rechargeable battery, a voltage v across the rechargeable battery, and a temperature T of the rechargeable battery. The parameters may be measured at time increments based on the battery data sampling time step $\Delta t$.

A value of the current i may be checked, at 210. The value the current i may be checked to determine how to process the current i, the voltage v, and the temperature T. For example, if no current is detected (e.g., i = 0), then the battery forecaster may continue to measure the parameters. If a negative current is detected (e.g., i < 0), then the rechargeable battery is being charged. The battery forecaster may calculate a first set of intermediate values when the current i is negative, at 212. The first set of values may be associated with the multiple charge operations. For example, the first set of intermediate values may include a time period (e.g., a duration) $\Delta t_{c,j}$ of the multiple charge operations and one or more calculations based on the current i, the voltage v, and the temperature T during the time period $\Delta t_{c,j}$. As a particular example, the first amount of electric charge applied to the rechargeable battery during the multiple charge operations may be determined by performing an integral of the absolute value of the current i for the time period $\Delta t_{c,j}$. If a positive current is detected (e.g., i > 0), then the rechargeable battery is being discharged. The battery forecaster may calculate a second set of intermediate values when the current i is positive, at 214. For example, the second set of intermediate values may include a time period (e.g., a duration) $\Delta t_{d,j}$ of the multiple discharge operations and one or more calculations based on the current i, the voltage v, and the temperature T during the time period $\Delta t_{d,j}$. As a particular example, the second amount of electric charge discharged from the rechargeable battery during the multiple discharge operations may be determined by performing an integral of the current i for the time period $\Delta t_{d,j}$. One or more parameters of the rechargeable battery may be estimated based on the first set of intermediate values and the second set of intermediate values, as further described herein.

The battery forecaster may determine whether the jth effective power cycle is complete, at 216. The determination may be based on a relationship of the first amount of electric charge (e.g., the amount of electric charge applied to the rechargeable battery during the multiple charge operations) and the second amount of electric charge (e.g., the amount of electric charge discharged from the rechargeable battery during the multiple discharge operations) to a threshold. The threshold may be the input error parameter $\varepsilon$ that indicates how closely the first amount of electric charge and the second amount of electric charge approximate a remaining capacity of a previous (e.g., a j - 1) effective power cycle. The jth effective power cycle may be complete when the Inequality 1 and Inequality 2 each evaluate to true:

$$\left| \overline{C}_{j-1} - \int_{\Delta t_{c,j}} |i| dt \right| < \varepsilon \qquad \text{Inequality (1)}$$

$$\left| \overline{C}_{j-1} - \int_{\Delta t_{d,j}} i \, dt \right| < \varepsilon \qquad \text{Inequality (2)}$$

Determining whether the jth effective power cycle is complete may include comparing an absolute value of a first difference between the remaining capacity of the previous effective power cycle and the first amount of electric charge to the input error parameter $\varepsilon$ (e.g., the threshold). Determining whether the jth effective power cycle is complete may also include comparing an absolute value of a second difference between the remaining capacity of the previous effective power cycle and the second amount of electric charge to the input error parameter $\varepsilon$. A determination that the jth effective power cycle is complete may be based on the absolute values of the first difference and the second difference being less than the input error parameter $\varepsilon$. In response to the determination that the jth effective power is complete, the method 200 continues to 218. If the absolute value of the first difference or the absolute value of the second difference is not less than the input error parameter $\varepsilon$, the jth effective power cycle continues and the method 200 returns to 208, where the battery forecaster continues to monitor the current i, the voltage v, and the temperature T.

Responsive to a determination that the jth effective power cycle is complete, a remaining capacity $\overline{C}_j$, an internal resistance $\overline{R}_j$, and a reversible potential $\overline{E}_j$ may be estimated for the jth effective power cycle, at 218. The remaining capacity $\overline{C}_j$, the internal resistance $\overline{R}_j$, and the reversible potential $\overline{E}_j$ may be time-averaged values for the jth effective power cycle. The remaining capacity $\overline{C}_j$ may be estimated using Equation 2, where $C_{c,j}$ is the first amount of electric charge applied during the multiple charge operations of the jth effective power cycle and $C_{d,j}$ is the second amount of electric charge discharged during the multiple discharge operations of the jth effective power cycle:

$$\overline{C}_j = \frac{1}{2}\left(C_{c,j} + C_{d,j}\right) \qquad \text{Equation (2)}$$

Based on Equation 2, the time period $\Delta t_j$ of the jth effective power cycle may be a sum of the time period $\Delta t_{c,j}$ and the time period $\Delta t_{d,j}$. The first amount of electric charge may be calculated by performing an integral of the current i measured during the multiple charge operations using Equation 3:

$$C_{c,j} = \int_{\Delta t_{c,j}} |i| dt \qquad \text{Equation (3)}$$

The second amount of electric charge may be calculated by performing an integral of the current i measured during the multiple discharge operations using Equation 4:

$$C_{d,j} = \int_{\Delta t_{d,j}} i\, dt \qquad \text{Equation (4)}$$

The internal resistance $\overline{R}_j$ may be estimated using Equation 5:

$$\overline{R}_j = \frac{\int_{\Delta t_{j,c}} v \cdot |i| \cdot dt - \int_{\Delta t_{j,d}} v \cdot i \cdot dt}{\int_{\Delta t_j} i^2 \cdot dt} \qquad \text{Equation (5)}$$

The reversible potential $\overline{E}_j$ may be estimated using Equation 6:

$$\overline{E}_j = \frac{\int_{\Delta t_{j,c}} v \cdot |i| \cdot dt + \int_{\Delta t_{j,d}} v \cdot i \cdot dt + \overline{R}_j \left( \int_{\Delta t_{j,d}} i^2 \cdot dt - \int_{\Delta t_{j,c}} i^2 \cdot dt \right)}{\int_{\Delta t_j} |i| \cdot dt} \qquad \text{Equation (6)}$$

As may be appreciated from Equations 2-6, the remaining capacity $\overline{C}_j$, the internal resistance $\overline{R}_j$ and the reversible potential $\overline{E}_j$ may be estimated without reliance on a statistical model of the rechargeable battery. Additionally, Equations 2-6 do not depend on variables associated with a specific type of rechargeable battery. For example, Equations 2-6 are not based on variables indicating a material or chemical used to manufacture the rechargeable battery, a power level of the rechargeable battery, a configuration of the rechargeable battery, or any other type-specific factor. Thus, the remaining capacity $\overline{C}_j$, the internal resistance $\overline{R}_j$ and the reversible potential $\overline{E}_j$ may be estimated independently of a type of rechargeable battery and independently of a statistical model associated with the rechargeable battery.

The internal resistance $\overline{R}_j$ and the reversible potential $\overline{E}_j$ may be calibrated to the reference temperature $T_{ref}$, at 220. In order to calibrate the internal resistance $\overline{R}_j$ and the reversible potential $\overline{E}_j$, a time-averaged temperature $\overline{T}_j$ of the rechargeable battery for the jth effective power cycle may be determined using Equation 7:

$$\overline{T}_j = \frac{\int_{\Delta t_j} T \cdot dt}{\Delta t_j} \qquad \text{Equation (7)}$$

The internal resistance $\overline{R}_j$ may be calibrated to the reference temperature based on the temperature $\overline{T}_j$, the reference temperature $T_{ref}$, and the temperature coefficient $\alpha$ of the rechargeable battery. For example, a temperature-calibrated (e.g., temperature-corrected) internal resistance $\overline{R}_{j,ref}$ may be estimated using Equation 8:

$$\overline{R}_{j,ref} = \frac{\overline{R}_j}{1 + \alpha\left(\overline{T}_j - T_{ref}\right)} \qquad \text{Equation (8)}$$

The reversible potential $\overline{E}_j$ may be calibrated to the reference temperature based on the temperature $\overline{T}_j$, the reference temperature $T_{ref}$, and the temperature coefficient $\alpha$ of the rechargeable battery. For example, a temperature-calibrated (e.g., temperature-corrected) reversible potential $\overline{E}_{j,ref}$ may be estimated using Equation 9:

$$\overline{E}_{j,ref} = \frac{T_{ref}}{\overline{T}_j} \cdot \overline{E}_j \qquad \text{Equation (9)}$$

Parameters indicating performance trends of the rechargeable battery, such as changes in the remaining capacity $\overline{C}_j$, the internal resistance $\overline{R}_j$, and the reversible potential $\overline{E}_j$ may be estimated for the jth effective power cycle, at 222. For example, a change in remaining capacity (e.g., a capacity fade) $\Delta C_j$, a change in internal resistance (e.g., a resistance increase) $\Delta R_{j,ref}$, and a change in reversible potential (e.g., a reversible potential loss) $\Delta E_{j,ref}$ may be estimated. The changes may be estimated by comparing values corresponding to the jth effective power cycle to values corresponding to a previous effective power cycle (e.g., the j - 1 effective power cycle). For example, the change in remaining capacity $\Delta C_j$ may be generated based on the remaining capacity $\overline{C}_j$ and a previous remaining capacity $\overline{C}_{j-1}$. If the jth effective power cycle is a first effective power cycle, initial values received during initialization may be used for the values corresponding to the previous effective power cycle.

The change in remaining capacity $\Delta C_j$ may be estimated using Equation 10:

$$\Delta C_j = \overline{C}_{j-1} - \overline{C}_j \qquad \text{Equation (10)}$$

The change in internal resistance $\Delta R_{j,ref}$ may be estimated using Equation 11:

$$\Delta R_{j,ref} = \overline{R}_{j,ref} - \overline{R}_{j-1,ref} \qquad \text{Equation (11)}$$

The change in reversible potential $\Delta E_{j,ref}$ may be estimated using Equation 12:

$$\Delta E_{j,ref} = \overline{E}_{j-1,ref} - \overline{E}_{j,ref} \qquad \text{Equation (12)}$$

Cumulative changes in the remaining capacity $\overline{C}_j$, the internal resistance $\overline{R}_j$, and the reversible potential $\overline{E}_j$ may be estimated for the jth effective power cycle, at 224. For example, a cumulative change in remaining capacity (e.g., a cumulative capacity fade) $\Delta C_j^{total}$, a cumulative change in internal resistance (e.g., a cumulative resistance increase) $\Delta R_{j,ref}^{total}$, and a cumulative change in reversible potential (e.g., a cumulative reversible potential loss) $\Delta E_{j,ref}^{total}$ may be estimated. The changes may be estimated by comparing values corresponding to the jth effective power cycle to the initial values received during initialization. For example, the cumulative change in remaining capacity $\Delta C_j^{total}$ may be generated based on the remaining capacity $\overline{C}_j$ and the initial capacity $C_0$.

The cumulative change in remaining capacity $\Delta C_j^{total}$ may be estimated using Equation 13, where $C_0$ is the initial capacity of the rechargeable battery received during initialization:

$$\Delta C_j^{total} = \sum_{k=1}^{k=j} \Delta C_k = C_0 - \overline{C}_j \qquad \text{Equation (13)}$$

The cumulative change in internal resistance $\Delta R_{j,ref}^{total}$ may be estimated using Equation 14, where $R_{0,ref}$ is the initial internal resistance of the rechargeable battery received during initialization:

$$\Delta R_{j,ref}^{total} = \sum_{k=1}^{k=j} \Delta R_{k,ref} = \overline{R}_{j,ref} - R_{0,ref} \qquad \text{Equation (14)}$$

The cumulative change in reversible potential $\Delta E_{j,ref}^{total}$ may be estimated using Equation 15, where $E_{0,ref}$ is the initial reversible potential of the rechargeable battery received during initialization:

$$\Delta E_{j,ref}^{total} = \sum_{k=1}^{k=j} \Delta E_{k,ref} = E_{0,ref} - \overline{E}_{j,ref} \qquad \text{Equation (15)}$$

A data log may be updated, at 226. For example, the data log may be stored in a memory, such as the data log 150 in the memory 108 of FIG. 1. The data log may store data indicating the estimated battery parameters of the rechargeable battery. For example, data indicating the remaining capacity $\overline{C}_j$, the internal resistance $\overline{R}_j$, the reversible potential $\overline{E}_j$, the change in remaining capacity $\Delta C_j$, the change in internal resistance $\Delta R_{j,ref}$, the change in reversible potential $\Delta E_{j,ref}$, the cumulative change in remaining capacity $\Delta C_j^{total}$, the cumulative change in internal resistance $\Delta R_{j,ref}^{total}$, the cumulative change in reversible potential $\Delta E_{j,ref}^{total}$, or a combination thereof, may be provided to the memory for storage in the data log after the jth effective power cycle is complete. The data log may include data indicating $C_{new}, R_{new}, E_{new}, \Delta C_{new}^{total}, \Delta R_{new}^{total},$ and $\Delta E_{new}^{total}$, which correspond to parameters of the rechargeable battery after the jth effective power cycle. The data log may be updated by setting $C_{new} = \overline{C}_j$, setting $R_{new} = \overline{R}_j$, setting $E_{new} = \overline{E}_j$, setting $\Delta C_{new}^{total} = \Delta C_j^{total}$, setting $\Delta R_{new}^{total} = \Delta R_{j,ref}^{total}$, and setting $\Delta E_{new}^{total} = \Delta E_{j,ref}^{total}$.

Updating the data log may include generating an output based on the data log. For example, the output may be generated based on $C_{new}, R_{new}, E_{new}, \Delta C_{new}^{total}, \Delta R_{new}^{total}, \Delta E_{new}^{total}$, or other parameter values indicated by data stored in the data log. The output may be generated for display on a display device, such as the display device 110 of FIG. 1. Generating the output may enable the user to monitor performance characteristics and trends of the rechargeable battery after each effective power cycle.

The data log may include an indication of a remaining life of the rechargeable battery. For example, the battery forecaster may estimate the remaining life of the rechargeable battery based on the remaining capacity $\overline{C}_j$ and input data indicating conditions of use of the rechargeable battery. For example, the conditions of use may include power output requirements, rates and/or durations of charge operations or discharge operations, temperature of use, or other data indicating how the rechargeable battery is being used. The input data may be received during the initialization of the battery parameters. The remaining life of the rechargeable battery may be estimated as a number of hours the rechargeable battery may be used at the particular conditions until an end of life of the rechargeable battery. Estimating the remaining life as the number of hours may provide a more user-friendly indication of remaining battery life than the remaining capacity $\overline{C}_j$.

The remaining capacity $\overline{C}_j$ may be compared to a threshold, at 228. The threshold may be a capacity threshold ($C_{threshold}$) that indicates a minimum capacity that the rechargeable battery can reach without causing problems during use. For example, the capacity threshold may be based on use conditions of the rechargeable battery, such as power requirements of a device being powered by the rechargeable battery. The capacity threshold may be received via user input during the initialization. If the remaining capacity $\overline{C}_j$ exceeds (e.g., is greater than) the capacity threshold, sufficient capacity remains in the rechargeable battery and the method 200 continues to 206. Returning to 206 causes the battery forecaster to estimate a second remaining capacity associated with a second effective power cycle (e.g., a j + 1 effective power cycle) in response to determining that the remaining capacity $\overline{C}_j$ exceeds the capacity threshold. For example, the battery forecaster may estimate a remaining capacity $\overline{C}_{j+1}$, an internal resistance $\overline{R}_{j+1}$, and a reversible potential $\overline{E}_{j+1}$ based on the current i, the voltage v, and the temperature T measured during the second effective power cycle.

If the remaining capacity $\overline{C}_j$ does not exceed (e.g., is less than or equal to) the capacity threshold $C_{threshold}$, the rechargeable battery no longer contains sufficient capacity for additional use (e.g., one or more problems may occur during additional use of the rechargeable battery). The battery forecaster may generate an indication of an end of life of the rechargeable battery for display via the display device. For example, a report may be generated based on the data log at the end of the user time, at 230. The end of the user time is indicated by the remaining capacity $\overline{C}_j$ being less than or equal to the capacity threshold $C_{thieshold}$. The report may be output via the display device. The report may include information indicating values of $C_{new}$, $R_{new}$, $E_{new}$, $\Delta C_{new}^{total}$, $\Delta R_{new}^{total}$, and $\Delta E_{new}^{total}$ estimated after a last effective power cycle, as well as a total number of effective power cycles and a total user time (e.g., a total duration of use of the rechargeable battery). The user may use the information in the report during selection of a replacement rechargeable battery, or for other purposes.

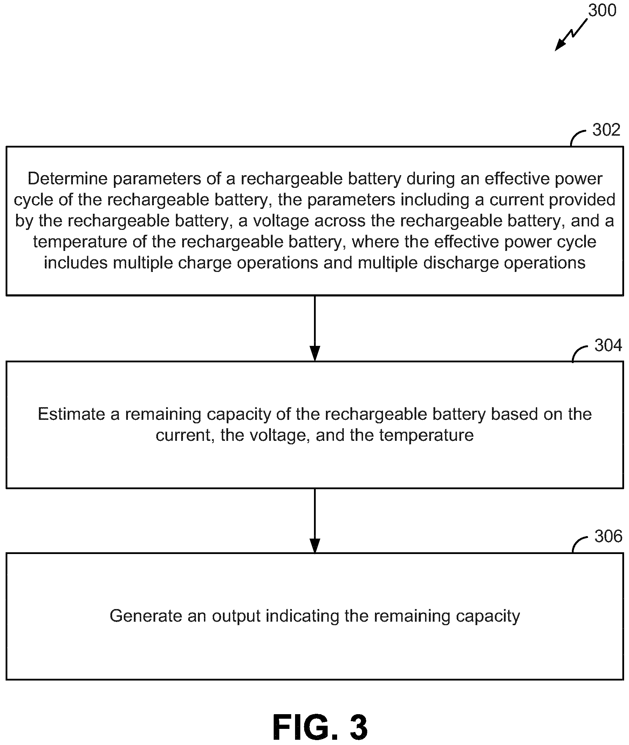

Referring to FIG. 3, a flow chart of a particular embodiment of a method 300 of estimating a remaining capacity of a rechargeable battery is depicted. The method 300 may be performed by a battery forecaster to estimate battery life or battery performance of the rechargeable battery. For example, the method 300 may be performed by the battery forecaster 106 on the rechargeable battery 102 of FIG. 1.

Parameters of the rechargeable battery are measured during an effective power cycle of the rechargeable battery, at 302. The parameters may include a current provided by the rechargeable battery, a voltage across the rechargeable battery, and a temperature of the rechargeable battery, such as the current 114, the voltage 116, and the temperature 118 of FIG. 1, respectively. The effective power cycle may include multiple charge operations and multiple discharge operations.

The remaining capacity of the rechargeable battery is estimated based on the current, the voltage, and the temperature, at 304. For example, the remaining capacity may be the remaining capacity 140 of FIG. 1 and may be estimated using Equations 2-4. An output indicating the remaining capacity may be generated, at 306. For example, the output may be the output 152 of FIG. 1. The output may be based on a data log storing data that indicates the remaining capacity, and the output may be displayed via a display device.

An internal resistance of the battery may be estimated based on the current, the voltage, and the temperature. For example, the internal resistance may be the internal resistance 142 of FIG. 1 and may be estimated using Equation 5. A reversible potential of the battery may also be estimated based on the current, the voltage, and the temperature. For example, the reversible potential may be the reversible potential 144 of FIG. 1 and may be estimated using Equation 6. The output may also indicate the internal resistance and the reversible potential. Additional values may be estimated based on the current, the voltage, and the temperature, as further explained with reference to FIGS. 1 and 2A-B.

The method 200 of FIGS. 2A-B and the method 300 of FIG. 3 may be initiated or controlled by a field-programmable gate array (FPGA) device, an application-specific integrated circuit (ASIC), a processing unit, such as a central processing unit (CPU), a digital signal processor (DSP), a controller, another hardware device, a firmware device, or any combination thereof. As an example, method 200 of FIGS. 2A-B and the method 300 of FIG. 3 may be initiated or controlled by one or more processors.

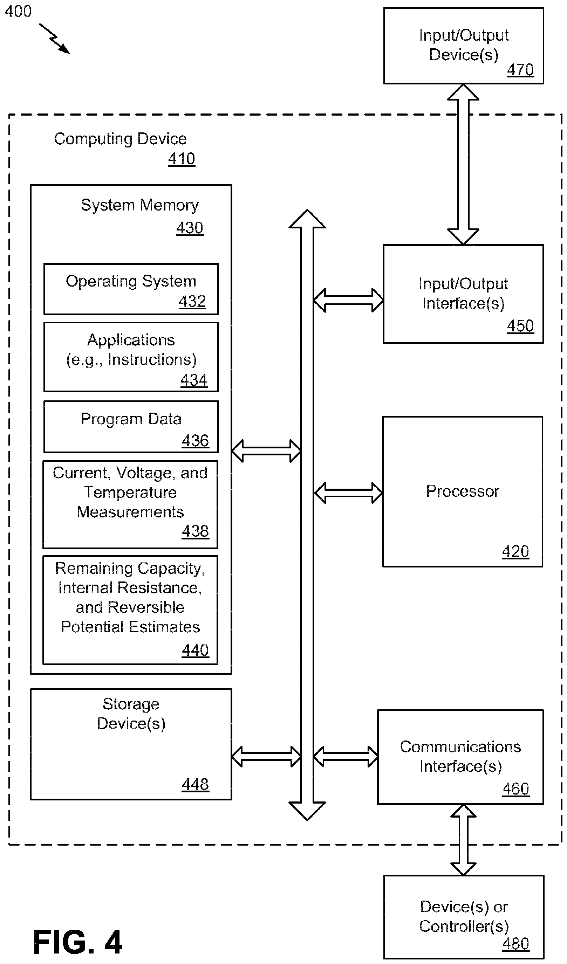

FIG. 4 is a block diagram of a computing environment 400 including a computing device 410 operable to estimate parameters indicating battery life and battery performance of a rechargeable battery. For example, the computing device 410 may be included within or correspond to the battery forecaster 106 of FIG. 1.

The computing device 410 may include at least one processor 420. Within the computing device 410, the at least one processor 420 may communicate with a system memory 430, one or more storage devices 448, one or more input/output interfaces 450, one or more communications interfaces 460, or a combination thereof.

The system memory 430 may include volatile memory devices (e.g., random access memory (RAM) devices), nonvolatile memory devices (e.g., read-only memory (ROM) devices, programmable read-only memory, and flash memory), or both. The system memory 430 may include an operating system 432, which may include a basic input/output system for booting the computing device 410 as well as a full operating system to enable the computing device 410 to interact with users, other programs, and other devices. The system memory 430 may also include one or more applications (e.g., instructions) 434, program data 436, data corresponding to current, voltage, and temperature measurements 438, and remaining capacity, internal resistance, and reversible potential estimates 440. The program data 436 may include data used by the applications 434 to perform respective functions of the applications 434. The applications 434 may include instructions executable by the at least one processor 420 to estimate one or more parameters associated with battery life and battery performance of a rechargeable battery. The current, voltage, and temperature measurements 438 may include values used during to generate the remaining capacity, internal resistance, and reversible potential estimates 440.

The one or more storage devices 448 may include nonvolatile storage devices, such as magnetic disks, optical disks, or flash memory devices. The storage devices 448 may include both removable and non-removable memory devices. In a particular embodiment, the storage devices 448 may be configured to store the operating system 432, the applications 434, the program data 436, the current, voltage, and temperature measurements 438, the remaining capacity, internal resistance, and reversible potential estimates 440, or a combination thereof. The system memory 430 and the storage devices 448 are physical devices and are not a signal.

In a particular embodiment, the at least one processor 420 is configured to execute computer executable instructions, such as the applications 434, stored at the system memory 430. The instructions may be executable to cause the at least one processor 420 to perform operations. The operations may include measuring parameters of a rechargeable battery during an effective power cycle of the rechargeable battery. The parameters may include a current provided by the rechargeable battery, a voltage across the rechargeable battery, and a temperature of the rechargeable battery. The effective power cycle may include multiple charge operations and multiple discharge operations. The operations may include estimating a remaining capacity of the rechargeable battery based on the current, the voltage, and the temperature (e.g., the current, voltage, and temperature measurements 438). The remaining capacity, internal resistance, and reversible potential estimates 440 may include the remaining capacity. The operations may further include generating an output indicating the remaining capacity.

The one or more input/output interfaces 450 may enable the computing device 410 to communicate with one or more input/output devices 470 to facilitate user interaction. For example, the one or more input/output interfaces 450 may be adapted to receive input from a user, to receive input from another computing device, or a combination thereof. The input/output interfaces 450 may conform to one or more standard interface protocols, including serial interfaces (e.g., universal serial bus (USB) interfaces or Institute of Electrical and Electronics Engineers (IEEE) interface standards), parallel interfaces, display adapters, audio adapters, or custom interfaces. The input/output devices 470 may include user interface devices and displays, including some combination of buttons, keyboards, pointing devices, displays, speakers, microphones, touch screens, and other devices. The processor 420 may detect interaction events based on user input received via the input/output interfaces 450. Additionally, the processor 420 may send a display to a display device via the input/output interfaces 450.

The one or more communications interfaces 460 may enable the computing device 410 to communicate with one or more other computing devices or controllers 480. The one or more communications interfaces 460 may include wired Ethernet interfaces, Institute of Electrical and Electronics Engineers (IEEE) 802 wireless interfaces, Bluetooth communication interfaces, electrical (or power line) interfaces, optical or radio frequency interfaces, or other wired or wireless interfaces. The other computer devices or controllers 480 may include host computers, servers, workstations, portable computers, telephones, tablet computers, or any other communication device or component.

Examples described above illustrate but do not limit the disclosure. It should also be understood that numerous modifications and variations are possible in accordance with the principles of the present disclosure. Accordingly, the scope of the disclosure is defined by the following claims and their equivalents.

The illustrations of the examples described herein are intended to provide a general understanding of the structure of the various embodiments. The illustrations are not intended to serve as a complete description of all of the elements and features of apparatus and systems that utilize the structures or methods described herein. Many other embodiments may be apparent to those of skill in the art upon reviewing the disclosure. Other embodiments may be utilized and derived from the disclosure, such that structural and logical substitutions and changes may be made without departing from the scope of the disclosure. For example, method steps may be performed in a different order than shown in the figures or one or more method steps may be omitted. Accordingly, the disclosure and the figures are to be regarded as illustrative rather than restrictive.

Moreover, although specific examples have been illustrated and described herein, it should be appreciated that any subsequent arrangement designed to achieve the same or similar results may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description.

The Abstract of the Disclosure is submitted with the understanding that it will not be used to interpret or limit the scope or meaning of the claims. In addition, in the foregoing Detailed Description, various features may be grouped together or described in a single embodiment for the purpose of streamlining the disclosure. As the following claims reflect, the claimed subject matter may be directed to less than all of the features of any of the disclosed examples.

## Claims

1. A method comprising:

repeatedly measuring parameters of a rechargeable battery (102) during an

effective power cycle j of the rechargeable battery, the parameters including a current i provided by the rechargeable battery (102), a voltage across the rechargeable battery (102), and a temperature of the rechargeable battery (102),
wherein the effective power cycle j includes multiple charge operations and multiple discharge operations, wherein the current i is positive during discharging of the battery and negative during charging of the battery, and wherein at each measurement:

- if the measured value of the current i is negative, then a first set of intermediate values is calculated, associated with the multiple charge operations, said first set of intermediate values including:

a time period $\Delta t_{c,j}$ of the multiple charge operations and
a first amount of electric charge $C_{c,j}$ applied to the rechargeable battery during the multiple charge operations, wherein

$$C_{c,j} = \int_{\Delta t_{c,j}} |i| dt \ ;$$

- if the measured value of the current i is positive, then a second set of intermediate values is calculated, associated with the multiple discharge operations, said second set of intermediate values including:

a time period $\Delta t_{d,j}$ of the multiple discharge operations and
a second amount of electric charge $C_{d,j}$ discharged from the rechargeable battery during the multiple discharge operations,

wherein

$$C_{d,j} = \int_{\Delta t_{d,j}} i \, dt \ ,$$

determining that the effective power cycle j is complete when the following inequalities are true:

$$\left| \overline{C}_k - C_{c,j} \right| < \varepsilon \ \text{and} \ \left| \overline{C}_k - C_{d,j} \right| < \varepsilon \ ,$$

wherein:

$\overline{C}_k$ is a remaining capacity determined at a previous effective power cycle
k, with k<j, and $\overline{C}_0$ is an initial capacity;
$\varepsilon$ is an error parameter;

in response to determining that the effective power cycle j is complete, estimating a remaining capacity $\overline{C}_j$ of the rechargeable battery (102) by the following formula:

$$\overline{C}_j = \frac{1}{2} \left( C_{c,j} + C_{d,j} \right);$$

and
generating an output indicating the remaining capacity $\overline{C}_j$.

2. The method of claim 1, further comprising:

   estimating an internal resistance of the rechargeable battery (102) based on the current, the voltage, and the temperature; and
   estimating a reversible potential of the rechargeable battery (102) based on the current, the voltage, and the temperature, wherein the output further indicates the internal resistance and the reversible potential.

3. The method of claim 2, further comprising calibrating the internal resistance and the reversible potential to a reference temperature based on the temperature, the reference temperature, and a temperature coefficient of the rechargeable battery (102).

4. The method of claim 1, further comprising comparing the remaining capacity to a threshold, wherein the output indicates an end of life of the rechargeable battery (102) when the remaining capacity is less than or equal to the threshold.

5. The method of claim 1, further comprising estimating a remaining life of the rechargeable battery based on the remaining capacity and input data indicating conditions of use of the rechargeable battery (102).

6. A system (100) comprising:

   a battery monitor (104) configured to repeatedly measure parameters of a rechargeable battery (102) during an effective power cycle j of the rechargeable battery (102), the parameters including a current i provided by the rechargeable battery, a voltage across the rechargeable battery, and a temperature of the rechargeable battery, wherein the effective power cycle j includes multiple charge operations and multiple discharge operations, wherein the current i is positive during discharging of the battery and negative during charging of the battery;
   a battery forecaster (106) configured to estimate a remaining capacity $\overline{C}_j$ of the rechargeable battery based on the current, the voltage, and the temperature; and
   a memory 108) coupled to the battery forecaster (106), the memory configured to store a data log (150) including data indicating the remaining capacity $\overline{C}_j$;
   wherein at each measurement, the battery forecaster (106) is adapted to :

   - if the measured value of the current i is negative, then calculate a first set of intermediate values, associated with the multiple charge operations, said first set of intermediate values including:

   a time period $\Delta t_{c,j}$ of the multiple charge operations and
   a first amount of electric charge $C_{c,j}$ applied to the rechargeable battery during the multiple charge operations, wherein

   $$C_{c,j} = \int_{\Delta t_{c,j}} |i| dt \ ;$$

   - if the measured value of the current i is positive, then calculate a second set of intermediate values, associated with the multiple discharge operations, said second set of intermediate values including:

   a time period $\Delta t_{d,j}$ of the multiple discharge operations and
   a second amount of electric charge $C_{d,j}$ discharged from the rechargeable battery during the multiple discharge operations, wherein

   $$C_{d,j} = \int_{\Delta t_{d,j}} i \, dt \ ,$$

   wherein the battery forecaster (106) is adapted to determine that the effective power cycle j is complete when the following inequalities are true:

$$\left| \overline{C}_k - C_{c,j} \right| < \varepsilon \text{ and } \left| \overline{C}_k - C_{d,j} \right| < \varepsilon,$$

wherein:

$\overline{C}_k$ is a remaining capacity determined at a previous effective power cycle k, with k<j, and $\overline{C}_0$ is an initial capacity;

$\varepsilon$ is an error parameter;

wherein the battery forecaster (106) is adapted to, in response to determining that the effective power cycle j is complete, estimate a remaining capacity $\overline{C}_j$ of the rechargeable battery (102) by the following formula:

$$\overline{C}_j = \frac{1}{2}\left( C_{c,j} + C_{d,j} \right);$$

and
generating an output indicating the remaining capacity $\overline{C}_j$.

7. The system of claim 6 wherein the battery forecaster is further comprising a computer device (410), wherein the computer device;
compares the remaining capacity to a threshold; and
estimates a second remaining capacity associated with a second effective power cycle in response to the remaining capacity exceeding the threshold,
receives one or more initial values based on a user input prior to determining the current, the voltage, and the temperature; and
initializes battery parameters based on the one or more initial values, wherein the remaining capacity is estimated further based on the initial values.

8. The system of claim 6, further comprising a display device coupled to the memory, wherein the display device is configured to display battery life and battery performance information based on the data log.

**Patentansprüche**

1. Verfahren mit den Schritten:

wiederholtes Messen von Parametern einer wiederaufladbaren Batterie (102) während eines effektiven Leistungszyklus j der wiederaufladbaren Batterie, wobei die Parameter einen durch die wiederaufladbare Batterie (102) bereitgestellten Strom i, eine Spannung über die wiederaufladbare Batterie (102) und eine Temperatur der wiederaufladbaren Batterie (102) aufweisen,
wobei der effektive Leistungszyklus j mehrere Ladevorgänge und mehrere Entladevorgänge aufweist,
wobei der Strom i während des Entladevorgangs der Batterie positiv und während des Ladevorgangs der Batterie negativ ist, und wobei bei jeder Messung:

- wenn der gemessene Wert des Stroms i negativ ist, ein erster Satz von Zwischenwerten berechnet wird, die den mehreren Ladevorgängen zugeordnet sind, wobei der erste Satz von Zwischenwerten aufweist:

eine Zeitdauer $\Delta t_{c,j}$ der mehreren Ladevorgänge und
eine erste elektrische Ladungsmenge $C_{c,j}$, die der wiederaufladbaren Batterie während der mehreren Ladevorgänge zugeführt wird, wobei

$$C_{c,j} = \int_{\Delta t_{c,j}} |i| \, dt;$$

- wenn der gemessene Wert des Stroms i positiv ist, ein zweiter Satz von Zwischenwerten berechnet wird, die den mehreren Entladevorgängen zugeordnet sind, wobei der zweite Satz von Zwischenwerten aufweist:

eine Zeitdauer $\Delta t_{d,j}$ der mehreren Entladevorgänge und
eine zweite elektrische Ladungsmenge $C_{d,j}$, die von der wiederaufladbaren Batterie während der mehreren Entladevorgänge entladen wird, wobei

$$C_{d,j} = \int_{\Delta t_{d,j}} i\,dt;$$

bestimmen, dass der effektive Leistungszyklus j abgeschlossen ist, wenn die folgenden Ungleichungen erfüllt sind:

$$\left| \bar{C}_k - C_{c,j} \right| < \varepsilon \text{ und } \left| \bar{C}_k - C_{d,j} \right| < \varepsilon,$$

wobei:

$\overline{C}_k$ eine in einem vorangegangenen effektiven Leistungszyklus k bestimmte Restkapazität ist, wobei k < j ist und $\overline{C}_0$ eine Anfangskapazität ist;
$\varepsilon$ ein Fehlerparameter ist;
als Antwort darauf, dass bestimmt wird, dass der effektive Leistungszyklus j abgeschlossen ist, eine Restkapazität $\overline{C}_j$ der wiederaufladbaren Batterie (102) durch die folgende Formel schätzen:

$$\bar{C}_j = \frac{1}{2}(C_{c,j} + C_{d,j});$$

und

Erzeugen einer die Restkapazität $\overline{C}_j$ anzeigenden Ausgabe.

2. Verfahren nach Anspruch 1, ferner aufweisend:

Schätzen eines Innenwiderstands der wiederaufladbaren Batterie (102) basierend auf dem Strom, der Spannung und der Temperatur; und
Schätzen eines reversiblen Potentials der wiederaufladbaren Batterie (102) basierend auf dem Strom, der Spannung und der Temperatur, wobei die Ausgabe ferner den Innenwiderstand und das reversible Potential angibt.

3. Verfahren nach Anspruch 2, ferner aufweisend ein Kalibrieren des Innenwiderstands und des reversiblen Potentials gegen eine Referenztemperatur basierend auf der Temperatur, der Referenztemperatur und einem Temperaturkoeffizienten der wiederaufladbaren Batterie (102).

4. Verfahren nach Anspruch 1, ferner aufweisend ein Vergleichen der Restkapazität mit einem Schwellenwert, wobei die Ausgabe ein Ende der Lebensdauer der wiederaufladbaren Batterie (102) anzeigt, wenn die Restkapazität kleiner oder gleich dem Schwellenwert ist.

5. Verfahren nach Anspruch 1, ferner aufweisend ein Schätzen einer Restlebensdauer der wiederaufladbaren Batterie basierend auf der Restkapazität und auf Eingabedaten, die Gebrauchszustände der wiederaufladbaren Batterie (102) angeben.

6. System (100) mit:

einer Batterieüberwachungseinrichtung (104), die dafür konfiguriert ist, Parameter einer wiederaufladbaren Batterie (102) während eines effektiven Leistungszyklus j der wiederaufladbaren Batterie (102) wiederholt zu messen, wobei die Parameter einen durch die wiederaufladbare Batterie bereitgestellten Strom i, eine Spannung über die wiederaufladbare Batterie und eine Temperatur der wiederaufladbaren Batterie aufweisen, wobei der effektive Leistungszyklus j mehrere Ladevorgänge und mehrere Entladevorgänge aufweist, wobei der Strom i während des Entladevorgangs der Batterie positiv und während des Ladevorgangs der Batterie negativ ist; einer Batterieprognoseeinrichtung (106), die dafür konfiguriert ist, eine Restkapazität $\overline{C}_j$ der wiederaufladbaren Batterie basierend auf dem Strom, der Spannung und der Temperatur zu schätzen; und einem mit der Batterieprognoseeinrichtung (106) verbundenen Speicher (108), wobei der Speicher dafür konfiguriert ist, ein Datenprotokoll (150) zu speichern, das die Restkapazität $\overline{C}_j$ angebende Daten aufweist;

wobei die Batterieprognoseeinrichtung (106) dazu geeignet ist, bei jeder Messung:

- wenn der gemessene Wert des Stroms i negativ ist, einen ersten Satz von Zwischenwerten zu berechnen, die den mehreren Ladevorgängen zugeordnet sind, wobei der erste Satz von Zwischenwerten aufweist:

eine Zeitdauer $\Delta t_{c,j}$ der mehreren Ladevorgänge und eine erste elektrische Ladungsmenge $C_{c,j}$, die der wiederaufladbaren Batterie während der mehreren Ladevorgänge zugeführt wird, wobei

$$C_{c,j} = \int_{\Delta t_{c,j}} |i| dt;$$

- wenn der gemessene Wert des Stroms i positiv ist, einen zweiten Satz von Zwischenwerten zu berechnen, die den mehreren Entladevorgängen zugeordnet sind, wobei der zweite Satz von Zwischenwerten aufweist:

eine Zeitdauer $\Delta t_{d,j}$ der mehreren Entladevorgänge und eine zweite elektrische Ladungsmenge $C_{d,j}$, die von der wiederaufladbaren Batterie während der mehreren Entladevorgänge entladen wird, wobei

$$C_{d,j} = \int_{\Delta t_{d,j}} i dt,$$

wobei die Batterieprognoseeinrichtung (106) dazu geeignet ist, zu bestimmen, dass der effektive Leistungszyklus j abgeschlossen ist, wenn die folgenden Ungleichungen erfüllt sind:

$$\left| \bar{C}_k - C_{c,j} \right| < \varepsilon \text{ und } \left| \bar{C}_k - C_{d,j} \right| < \varepsilon,$$

wobei:

$\overline{C}_k$ eine in einem vorangegangenen effektiven Leistungszyklus k bestimmte Restkapazität ist, wobei k < j ist und $\overline{C}_0$ eine Anfangskapazität ist; $\varepsilon$ ein Fehlerparameter ist,

wobei die Batterieprognoseeinrichtung (106) dazu geeignet ist, als Antwort darauf, dass bestimmt wird, dass der effektive Leistungszyklus j abgeschlossen ist, eine Restkapazität $\overline{C}_j$ der wiederaufladbaren Batterie (102) durch die folgende Formel zu schätzen:

$$\bar{C}_j = \frac{1}{2}(C_{c,j} + C_{d,j});$$

und eine die Restkapazität $\overline{C}_j$ angebende Ausgabe zu erzeugen.

7. System nach Anspruch 6, wobei die Batterieprognoseeinrichtung ferner eine Computereinrichtung (410) aufweist, wobei die Computereinrichtung:

die Restkapazität mit einem Schwellenwert vergleicht; und eine einem zweiten effektiven Leistungszyklus zugeordnete zweite Restkapazität als Antwort darauf schätzt, dass die Restkapazität den Schwellenwert überschreitet;

einen oder mehrere auf einer Benutzereingabe basierende Anfangswerte vor der Bestimmung des Stroms, der Spannung und der Temperatur empfängt; und

Batterieparameter basierend auf dem einen oder den mehreren Anfangswerten initialisiert, wobei die Restkapazität ferner basierend auf den Anfangswerten geschätzt wird.

**8.** System nach Anspruch 6, ferner mit einer mit dem Speicher verbundenen Displayeinrichtung, wobei die Displayeinrichtung dafür konfiguriert ist, Batterielebensdauer- und Batterieleistungsinformationen basierend auf dem Datenprotokoll anzuzeigen.

**Revendications**

**1.** Procédé comprenant :

la mesure à plusieurs reprises de paramètres d'une batterie rechargeable (102) pendant un cycle de puissance efficace j de la batterie rechargeable, les paramètres incluant un courant i fourni par la batterie rechargeable (102), une tension aux bornes de la batterie rechargeable (102), et une température de la batterie rechargeable (102),

dans lequel le cycle de puissance efficace j inclut de multiples opérations de charge et de multiples opérations de décharge,

dans lequel le courant i est positif pendant une décharge de la batterie et négatif pendant une charge de la batterie, et dans lequel à chaque mesure :

- si la valeur mesurée du courant i est négative, alors un premier jeu de valeurs intermédiaires est calculé, associé aux multiples opérations de charge, ledit premier jeu de valeurs intermédiaires incluant :

une durée $\Delta t_{c,j}$ des multiples opérations de charge et
une première quantité de charge électrique $C_{c,j}$ appliquée à la batterie rechargeable pendant les multiples opérations de charge, dans lequel

$$C_{c,j} = \int_{\Delta t_{c,j}} |i| dt \; ;$$

- si la valeur mesurée du courant i est positive, alors un second jeu de valeurs intermédiaires est calculé, associé aux multiples opérations de décharge, ledit second jeu de valeurs intermédiaires incluant :

une durée $\Delta t_{d,j}$ des multiples opérations de décharge et
une seconde quantité de charge électrique $C_{d,j}$ déchargée de la batterie rechargeable pendant les multiples opérations de décharge,

dans lequel

$$C_{d,j} = \int_{\Delta t_{d,j}} i \, dt \; ,$$

la détermination que le cycle de puissance efficace j est achevé lorsque les inégalités suivantes sont satisfaites :

$$\left| \overline{C}_k - C_{c,j} \right| < \varepsilon \text{ et } \left| \overline{C}_k - C_{d,j} \right| < \varepsilon ,$$

dans lequel :

$\overline{C}_k$ est une capacité restante déterminée à un cycle de puissance efficace précédent k, avec k < j, et $\overline{C}_0$ est une capacité initiale ;

$\varepsilon$ est un paramètre d'erreur ;

en réponse à la détermination que le cycle de puissance efficace j est achevé,
l'estimation d'une capacité restante $\overline{C}_j$ de la batterie rechargeable (102) par la formule suivante :

$$\overline{C}_j = \frac{1}{2}\left(C_{c,j} + C_{d,j}\right)_;$$

et
la génération d'une sortie indiquant la capacité restante $\overline{C}_j$.

2. Procédé selon la revendication 1, comprenant en outre :

l'estimation d'une résistance interne de la batterie rechargeable (102) en se basant sur le courant, la tension et la température ; et
l'estimation d'un potentiel réversible de la batterie rechargeable (102) en se basant sur le courant, la tension, et la température, dans lequel la sortie indique en outre la résistance interne et le potentiel réversible.

3. Procédé selon la revendication 2, comprenant en outre l'étalonnage de la résistance interne et du potentiel réversible à une température de référence basé sur la température, la température de référence, et un coefficient de température de la batterie rechargeable (102).

4. Procédé selon la revendication 1, comprenant en outre la comparaison de la capacité restante à un seuil, dans lequel la sortie indique une fin de vie de la batterie rechargeable (102) lorsque la capacité restante est inférieure ou égale au seuil.

5. Procédé selon la revendication 1, comprenant en outre l'estimation d'une vie restante de la batterie rechargeable en se basant sur la capacité restante et des données d'entrée indiquant des conditions d'utilisation de la batterie rechargeable (102).

6. Système (100) comprenant :

un moniteur de batterie (104) configuré pour mesurer à plusieurs reprises des paramètres d'une batterie rechargeable (102) pendant un cycle de puissance efficace j de la batterie rechargeable (102), les paramètres incluant un courant i fourni par la batterie rechargeable, une tension aux bornes de la batterie rechargeable, et une température de la batterie rechargeable, dans lequel le cycle de puissance efficace j inclut de multiples opérations de charge et de multiples opérations de décharge, dans lequel le courant i est positif pendant une décharge de la batterie et négatif pendant une charge de la batterie ;
un prévisionniste de batterie (106) configuré pour estimer une capacité restante $\overline{C}_j$ de la batterie rechargeable en se basant sur le courant, la tension, et la température ; et
une mémoire (108) couplée au prévisionniste de batterie (106), la mémoire étant configurée pour stocker un journal de données (150) incluant des données indiquant la capacité restante $\overline{C}_j$ ;
dans lequel à chaque mesure, le prévisionniste de batterie (106) est adapté pour :

- si la valeur mesurée du courant i est négative, alors calculer un premier jeu de valeurs intermédiaires, associé aux multiples opérations de charge, ledit premier jeu de valeurs intermédiaires incluant :

une durée $\Delta t_{c,j}$ des multiples opérations de charge et
une première quantité de charge électrique $C_{c,j}$ appliquée à la batterie rechargeable pendant les multiples opérations de charge, dans lequel

$$C_{c,j} = \int\limits_{\Delta t_{c,j}} |i| dt \; ;$$

- si la valeur mesurée du courant i est positive, alors calculer un second jeu de valeurs intermédiaires, associé aux multiples opérations de décharge, ledit second jeu de valeurs intermédiaires incluant :

une durée $\Delta t_{d,j}$ des multiples opérations de décharge et
une seconde quantité de charge électrique $C_{d,j}$ déchargée de la batterie rechargeable pendant les multiples opérations de décharge,

dans lequel

$$C_{d,j} = \int\limits_{\Delta t_{d,j}} i\, dt \; ,$$

dans lequel le prévisionniste de batterie (106) est adapté pour déterminer que le cycle de puissance efficace j est achevé lorsque les inégalités suivantes sont satisfaites :

$$\left| \overline{C}_k - C_{c,j} \right| < \varepsilon \;\; \text{et} \;\; \left| \overline{C}_k - C_{d,j} \right| < \varepsilon \; ,$$

dans lequel :

$\overline{C}_k$ est une capacité restante déterminée à un cycle de puissance efficace précédent k, avec k < j, et $\overline{C}_0$ est une capacité initiale ;
$\varepsilon$ est un paramètre d'erreur ;
dans lequel le prévisionniste de batterie (106) est adapté pour, en réponse au fait de déterminer que le cycle de puissance efficace j est achevé, estimer une capacité
restante $\overline{C}_j$ de la batterie rechargeable (102) par la formule suivante :

$$\overline{C}_j = \frac{1}{2}\left( C_{c,j} + C_{d,j} \right) \; ;$$

et

la génération d'une sortie indiquant la capacité restante $\overline{C}_j$.

7. Système selon la revendication 6, dans lequel le prévisionniste de batterie comprend en outre un dispositif d'ordinateur (410), dans lequel le dispositif d'ordinateur ;
compare la capacité restante à un seuil ; et
estime une seconde capacité restante associée à un second cycle de puissance efficace en réponse au fait que la capacité restante dépasse le seuil,
reçoit une ou plusieurs valeurs initiales basées sur une entrée d'utilisateur avant de déterminer le courant, la tension, et la température ; et
initialise des paramètres de batterie en se basant sur les une ou plusieurs valeurs initiales, dans lequel la capacité restante est estimée en se basant en outre sur les valeurs initiales.

8. Système selon la revendication 6, comprenant en outre un dispositif d'affichage couplé à la mémoire, dans lequel le dispositif d'affichage est configuré pour afficher une durée de vie de batterie et des informations de performance de batterie basées sur le journal de données.

FIG. 1

200

Start

202
Initialize Battery Parameters

204
Start user time clock;
Set j = 0

206
j = j + 1;
Start jth effective power cycle

208
Measure and log battery voltage v,
current i, and temperature T

210
Check i value

i = 0

i > 0

i < 0

212
Calculate a first set of
intermediate values for all times
that i < 0

214
Calculate a second set of
intermediate values for all times
that i > 0

216
jth effective
power cycle
complete?

No

Yes

A

B

**FIG. 2A**

200

A

B

Estimate remaining capacity, internal resistance, and reversible potential for jth effective power cycle ⌐ 218

Calibrate the internal resistance and the reversible potential to a reference temperature ⌐ 220

Estimate remaining capacity change, internal resistance change, and reversible potential change for jth effective power cycle ⌐ 222

Estimate cumulative capacity change, cumulative internal resistance change, and cumulative reversible potential change ⌐ 224

Update data log ⌐ 226

Remaining capacity > threshold? ⌐ 228 — Yes

No

Generate report based on the data log at the end of the user time ⌐ 230

# FIG. 2B

300

302

Determine parameters of a rechargeable battery during an effective power cycle of the rechargeable battery, the parameters including a current provided by the rechargeable battery, a voltage across the rechargeable battery, and a temperature of the rechargeable battery, where the effective power cycle includes multiple charge operations and multiple discharge operations

304

Estimate a remaining capacity of the rechargeable battery based on the current, the voltage, and the temperature

306

Generate an output indicating the remaining capacity

# FIG. 3

400

Computing Device
410

System Memory
430

Operating System
432

Applications
(e.g., Instructions)
434

Program Data
436

Current, Voltage, and
Temperature
Measurements
438

Remaining Capacity,
Internal Resistance,
and Reversible
Potential Estimates
440

Storage
Device(s)
448

Input/Output
Device(s)
470

Input/Output
Interface(s)
450

Processor

420

Communications
Interface(s)
460

Device(s) or
Controller(s)
480

# FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1460709 A